# FASCICULE DE BREVET EUROPEEN

(11) **EP 3 761 378 B1**
(45) Date de publication et mention de la délivrance du brevet: **21.07.2021**
(21) Numéro de dépôt: 20183138.5
(22) Date de dépôt: 30.06.2020
(51) Int. Cl.: H01L 31/18

(54) **PROCEDE DE PASSIVATION**
PASSIVIERUNGSVERFAHREN
PASSIVATION PROCESS

(30) Priorité: 01.07.2019 FR 1907245
(43) Date de publication de la demande: 06.01.2021
(73) Titulaire: Commissariat à l'Energie Atomique et aux Energies Alternatives, 75015 Paris (FR)
(72) Inventeur: CABAL, Raphaël, 38054 GRENOBLE Cedex 09 (FR); GRANGE, Bernadette, 38054 GRENOBLE Cedex 09 (FR)
(74) Mandataire: INNOV-GROUP

(56) Documents cités:
- EP-A2- 2 051 307
- CN-A- 102 593 253
- KR-A- 20110 075 992
- US-B1- 6 734 037
- Alan E Delahoy ET AL: "Transparent Conducting Oxides for Photovoltaics", Handbook of Photovoltaic Science and Engineering, Second Edition, 21 décembre 2010 (2010-12-21), pages 716-796, XP055113336, Chichester, UK DOI: 10.1002/9780470974704.ch17 Extrait de l'Internet: URL:http://onlinelibrary.wiley.com/store/1 0.1002/9780470974704.ch17/asset/ch17.pdf?v =1&t=httq5av5&s=715bf24b1ef9939078e15755bc 65ffe9a23689ca [extrait le 2014-04-10]
- SPIEGEL M ET AL: "Detailed study on microwave induced remote hydrogen plasma passivation of multicrystalline silicon", PROCEEDINGS OF THE EUROPEAN PHOTOVOLTAIC SOLAR ENERGY CONFERENCE, XX, XX, vol. I, 23 octobre 1995 (1995-10-23), pages 421-424, XP002160391,
- SPIEGEL M ET AL: "Ribbon growth on substrate (RGS) silicon solar cells with microwave-induced remote hydrogen plasma passivation and efficiencies exceeding 11% - Operating Principles, Technology, and System Applications", SOLAR ENERGY MATERIALS AND SOLAR CELLS, ELSEVIER SCIENCE PUBLISHERS, AMSTERDAM, NL, vol. 55, no. 4, 4 septembre 1998 (1998-09-04), pages 331-340, XP004153254, ISSN: 0927-0248, DOI: 10.1016/S0927-0248(98)00095-6

## Description

### Domaine technique

L'invention se rapporte au domaine technique de la passivation d'une surface d'un substrat à base de silicium cristallin.

L'invention trouve notamment son application dans la fabrication de cellules photovoltaïques à homojonction comportant au moins une couche d'oxyde transparent conducteur.

### État de l'art

Une cellule photovoltaïque connue de l'état de la technique, comporte un empilement comprenant successivement :
- un substrat à base de silicium cristallin, revêtu d'une couche de silicium amorphe,
- au moins une couche d'oxyde transparent conducteur,
- une électrode métallique formant un contact électrique.

La ou les couches d'oxyde transparent conducteur permettent notamment d'assurer le contact électrique entre l'électrode métallique et le substrat. La ou les couches d'oxyde transparent conducteur peuvent également posséder un rôle de couche antireflet de par une épaisseur adaptée. La couche antireflet permet de réduire les pertes optiques liées aux réflexions du rayonnement lumineux, et donc d'optimiser l'absorption du rayonnement lumineux par le substrat. Le document KR 2011 0075992 A divulgue un procédé de passivation, comportant les étapes successives: prévoir un empilement comportant successivement un substrat à base de silicium cristallin, une couche de silicium et une couche d'oxyde transparent conducteur ou de SiO₂; et appliquer un plasma hydrogéné à l'empilement.

Toutefois, la ou les couches d'oxyde transparent conducteur ne sont pas entièrement satisfaisantes dans la mesure où elles ne permettent pas de passiver la surface du substrat, c'est-à-dire neutraliser les défauts électriquement actifs à la surface du substrat (i.e. à l'interface entre le substrat et la couche de silicium amorphe), ce qui est préjudiciable en termes de rendement de conversion de la cellule photovoltaïque. La passivation de la surface du substrat est assurée par la couche de silicium amorphe qui présente l'inconvénient d'être fortement absorbante dans les ultraviolets. Un compromis doit donc être recherché pour l'épaisseur de la couche de silicium amorphe afin de maximiser le rendement de conversion.

### Exposé de l'invention

L'invention vise à remédier en tout ou partie aux inconvénients précités. A cet effet, l'invention a pour objet un procédé de passivation, comportant les étapes successives :
a) prévoir un empilement comportant successivement un substrat à base de silicium cristallin, une couche d'oxyde de silicium, et au moins une couche d'oxyde transparent conducteur ;
b) appliquer un plasma hydrogéné à l'empilement, l'étape b) étant exécutée à une température adaptée de sorte que des atomes d'hydrogène du plasma hydrogéné diffusent jusqu'à l'interface entre le substrat et la couche d'oxyde de silicium.

Ainsi, un tel procédé selon l'invention permet de passiver la surface du substrat, malgré la présence de la ou des couches d'oxyde transparent conducteur, et ce grâce à l'étape b). En effet, l'hydrogène du plasma hydrogéné diffuse sous forme atomique jusqu'à l'interface entre le substrat et la couche d'oxyde de silicium et est en particulier susceptible de saturer les liaisons pendantes à la surface du substrat. Un tel procédé selon l'invention permet de s'affranchir de la présence d'une couche de silicium amorphe pour passiver la surface du substrat.

### Définitions

- Par «passivation », on entend la neutralisation de défauts électriquement actifs à la surface du substrat. En effet, la surface d'un substrat en silicium cristallin présente une densité de défauts (e.g. liaisons pendantes, impuretés, discontinuité du cristal etc.) pouvant entraîner des pertes non négligeables liées à la recombinaison en surface des porteurs dans le cas d'une application photovoltaïque.
- Par « substrat », on entend un support physique, autoporté, destiné à la fabrication d'une cellule photovoltaïque. Le substrat peut être une tranche (« *wafer »* en langue anglaise) découpée dans un lingot de silicium cristallin.
- Par « cristallin », on entend la forme multicristalline ou la forme monocristalline du silicium, excluant donc le silicium amorphe.
- Par « à base de », on entend que le silicium cristallin est le matériau principal et majoritaire composant le substrat.
- Par « oxyde de silicium », on entend le dioxyde de silicium SiO₂ ou ses dérivés SiOₓ non stœchiométriques.
- Par « oxyde transparent conducteur » (TCO pour « *Transparent Conductive Oxide* » en langue anglaise), on entend un oxyde transparent dans tout ou partie du spectre solaire, et électriquement conducteur. Par exemple, l'oxyde transparent conducteur peut présenter une transmittance supérieure ou égale à 60% (de préférence supérieure ou égale à 80%) sur le spectre [300 nm, 900 nm].
- Par « plasma hydrogéné », on entend un plasma où l'espèce gazeuse comporte des atomes d'hydrogène.

Le procédé selon l'invention peut comporter une ou plusieurs des caractéristiques suivantes.

Selon une caractéristique de l'invention, le plasma hydrogéné appliqué lors de l'étape b) comporte au moins un gaz sélectionné parmi NH₃ et H₂.

Ainsi, un avantage procuré est la facilité de mise en œuvre de tels plasmas hydrogéné, en particulier un plasma de NH₃.

Selon une caractéristique de l'invention, la température à laquelle est exécutée l'étape b) est comprise entre 340°C et 600°C, préférentiellement comprise entre 400°C et 550°C, plus préférentiellement comprise entre 400°C et 500°C.

Ainsi, un avantage procuré par de telles gammes de température est de permettre une diffusion des atomes d'hydrogène (activation thermique) jusqu'à l'interface entre le substrat et la couche d'oxyde de silicium, tout en évitant de dégrader la ou les couches d'oxyde transparent conducteur ainsi que la couche d'oxyde de silicium.

Selon une caractéristique de l'invention, le plasma hydrogéné est appliqué lors de l'étape b) selon une densité de puissance comprise entre 10⁻³ W.cm⁻² et 2.10⁻² W.cm⁻², préférentiellement comprise 5.10⁻³ W.cm⁻² et 10⁻² W.cm⁻².

Par « puissance », on entend la puissance injectée pour créer et entretenir le plasma.

Par « densité », on entend la puissance divisée par la surface développée des électrodes utilisées pour créer le plasma.

Ainsi, un avantage procuré est d'améliorer la passivation de l'interface entre le substrat et la couche d'oxyde de silicium.

Selon une caractéristique de l'invention, le plasma hydrogéné est appliqué lors de l'étape b) selon une pression comprise entre 1,5 Torr et 2,5 Torr, préférentiellement comprise entre 1,7 Torr et 2,2 Torr.

Ainsi, un avantage procuré est d'améliorer la passivation de l'interface entre le substrat et la couche d'oxyde de silicium.

Selon une caractéristique de l'invention, l'étape b) est exécutée sous une atmosphère comportant un gaz inerte sélectionné parmi Ar, N₂.

Ainsi, un avantage procuré est d'améliorer la stabilité et l'homogénéité du plasma hydrogéné.

Selon une caractéristique de l'invention, l'étape b) est exécutée pendant une durée comprise entre 5 minutes et 90 minutes, de préférence comprise entre 10 minutes et 30 minutes.

Ainsi, un avantage procuré est d'éviter d'avoir des temps d'opération trop longs, préjudiciable pour une mise en œuvre du procédé à l'échelle industrielle.

Selon une caractéristique de l'invention, la couche d'oxyde de silicium de l'empilement prévu lors de l'étape a) présente une épaisseur inférieure ou égale à 4 nm, de préférence inférieure ou égale à 2 nm.

Ainsi, un avantage procuré est de protéger le substrat sans affecter significativement la conductivité électrique de l'empilement pour le déplacement des porteurs de charge.

Selon une caractéristique de l'invention, la ou les couches d'oxyde transparent conducteur présentent une épaisseur totale comprise entre 10 nm et 200 nm.

Ainsi, un avantage procuré est d'obtenir un bon compromis entre conductivité électrique (pour le déplacement des porteurs de charge) et temps d'opération de dépôt de la ou des couches d'oxyde transparent conducteur.

Selon une caractéristique de l'invention, l'oxyde transparent conducteur est sélectionné parmi un oxyde d'indium et un oxyde de zinc ; l'oxyde d'indium étant de préférence choisi parmi l'oxyde d'indium-étain, un oxyde d'indium dopé au fluor, un oxyde d'indium hydrogéné, un oxyde d'indium dopé au tungstène ; l'oxyde de zinc étant de préférence choisi parmi un oxyde de zinc dopé à l'aluminium, un oxyde de zinc dopé au bore.

Selon une caractéristique de l'invention, l'oxyde transparent conducteur est sélectionné parmi un oxyde de zinc, un oxyde de zinc dopé à l'aluminium, un oxyde de zinc dopé au bore.

On privilégiera un oxyde de zinc dans la mesure où l'indium est coûteux avec des ressources limitées, et est de plus un contaminant susceptible de dégrader la durée de vie des porteurs de charge au sein de l'empilement.

Selon une caractéristique de l'invention, l'étape a) comporte une étape a₁) consistant à former une couche d'alumine sur la ou les couches d'oxyde transparent conducteur.

Par « alumine », on entend l'oxyde d'aluminium de formule Al₂O₃ ou ses dérivés AlOₓ non stœchiométriques.

Ainsi, un avantage procuré est d'améliorer la passivation de l'interface entre le substrat et la couche d'oxyde de silicium.

Selon une caractéristique de l'invention, l'étape a₁) est exécutée de sorte que la couche d'alumine présente une épaisseur inférieure ou égale à 20 nm, de préférence comprise entre 2 nm et 10 nm.

Ainsi, de telles épaisseurs permettent d'améliorer la passivation de l'interface entre le substrat et la couche d'oxyde de silicium sans affecter significativement la conductivité électrique de l'empilement pour le déplacement des porteurs de charge.

Selon une caractéristique de l'invention, l'étape a₁) est exécutée par une technique de dépôt choisie parmi l'ALD, un dépôt physique en phase vapeur, et un dépôt chimique en phase vapeur.

Selon une caractéristique de l'invention, l'étape a) est exécutée de sorte qu'une couche de silicium polycristallin est intercalée entre la couche d'oxyde de silicium et la ou les couches d'oxyde transparent conducteur.

Ainsi, un avantage procuré est d'améliorer la passivation de l'interface entre le substrat et la couche d'oxyde de silicium.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 est une vue schématique en coupe illustrant un premier mode de réalisation d'un empilement soumis à un procédé selon l'invention.
Figure 2 est une vue schématique en coupe illustrant un deuxième mode de réalisation d'un empilement soumis à un procédé selon l'invention.
Figure 3 est une vue schématique en coupe illustrant un troisième mode de réalisation d'un empilement soumis à un procédé selon l'invention.
Figure 4 est une vue schématique en coupe illustrant un quatrième mode de réalisation d'un empilement soumis à un procédé selon l'invention.

Les figures ne sont pas représentées à l'échelle pour en simplifier leur compréhension.

### Exposé détaillé des modes de réalisation

Les éléments identiques ou assurant la même fonction porteront les mêmes références pour les différents modes de réalisation, par souci de simplification.

Un objet de l'invention est un procédé de passivation, comportant les étapes successives :
a) prévoir un empilement 1 comportant successivement un substrat 2 à base de silicium cristallin, une couche d'oxyde de silicium 3, et au moins une couche d'oxyde transparent conducteur 4 ;
b) appliquer un plasma hydrogéné à l'empilement 1, l'étape b) étant exécutée à une température adaptée de sorte que des atomes d'hydrogène du plasma hydrogéné diffusent jusqu'à l'interface I entre le substrat 2 et la couche d'oxyde de silicium 3.

### Empilement

Le substrat 2 présente préférentiellement une épaisseur strictement inférieure à 250 µm. Le silicium à base duquel est réalisé le substrat 2 peut être monocristallin ou polycristallin. Le substrat 2 peut être dopé de type n ou de type p. L'empilement 1 peut s'intégrer en surface avant et/ou en surface arrière d'une cellule photovoltaïque à homojonction, par exemple une cellule photovoltaïque de type PERC (« *Passivated Emitter and Rear Cell »* en langue anglaise).

La couche d'oxyde de silicium 3 de l'empilement 1 prévu lors de l'étape a) présente avantageusement une épaisseur inférieure ou égale à 4 nm, de préférence inférieure ou égale à 2 nm. De manière générale, la couche d'oxyde de silicium 3 est suffisamment fine afin de ne pas affecter significativement la conductivité électrique de l'empilement 1 pour le déplacement des porteurs de charge. L'étape a) est exécutée de sorte que la couche d'oxyde de silicium 3 est introduite entre le substrat 2 et la ou les couches d'oxyde transparent conducteurs 4. L'empilement 1 est dépourvu d'une couche de silicium amorphe.

La ou les couches d'oxyde transparent conducteur 4 sont avantageusement formées sur la couche d'oxyde de silicium par une technique de dépôt choisie parmi l'ALD (« *Atomic Layer Deposition* » en langue anglaise), un dépôt physique en phase vapeur (PVD pour « *Physical Vapor Deposition* » en langue anglaise), et un dépôt chimique en phase vapeur assisté par plasma (PECVD pour « *Plasma Enhanced Chimical Vapor Deposition* » en langue anglaise). La ou les couches d'oxyde transparent conducteur 4 présentent avantageusement une épaisseur totale comprise entre 10 nm et 200 nm. L'oxyde transparent conducteur est avantageusement sélectionné parmi un oxyde d'indium et un oxyde de zinc. L'oxyde d'indium est de préférence choisi parmi l'oxyde d'indium-étain, un oxyde d'indium dopé au fluor, un oxyde d'indium hydrogéné, un oxyde d'indium dopé au tungstène. L'oxyde de zinc est de préférence choisi parmi un oxyde de zinc dopé à l'aluminium, un oxyde de zinc dopé au bore. L'oxyde transparent conducteur est avantageusement sélectionné parmi un oxyde de zinc, un oxyde de zinc dopé à l'aluminium, un oxyde de zinc dopé au bore.

Une seule couche d'oxyde transparent conducteur 4 est illustrée aux figures annexées, mais il est tout à fait envisageable de prévoir un empilement de plusieurs couches d'oxyde transparent conducteur 4, pouvant être par exemple réalisées dans différents oxydes transparents conducteurs.

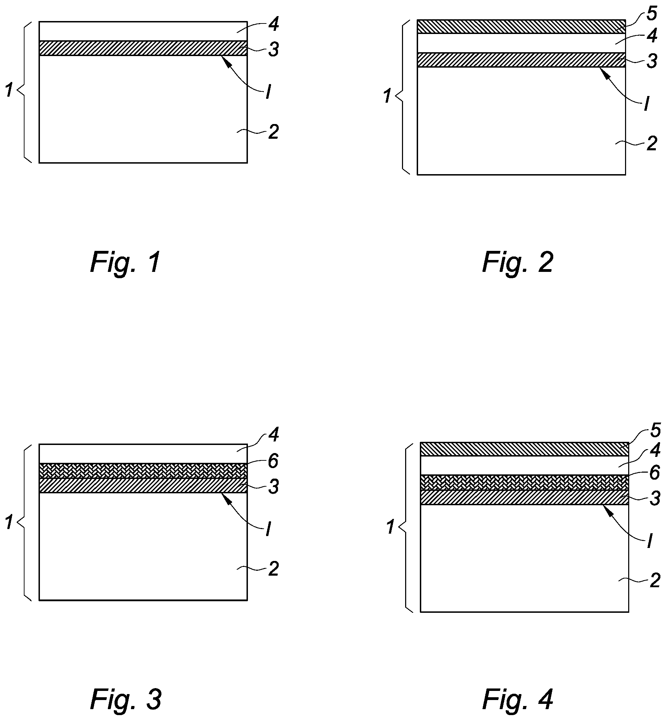

Comme illustré aux figures 2 et 4, l'étape a) comporte avantageusement une étape a₁) consistant à former une couche d'alumine 5 sur la ou les couches d'oxyde transparent conducteur 4. L'étape a₁) est avantageusement exécutée de sorte que la couche d'alumine 5 présente une épaisseur inférieure ou égale à 20 nm, de préférence comprise entre 2 nm et 10 nm. L'étape a₁) est avantageusement exécutée par une technique de dépôt choisie parmi l'ALD (« *Atomic Layer Deposition »* en langue anglaise), un dépôt physique en phase vapeur (PVD pour « *Physical Vapor Deposition* » en langue anglaise), et un dépôt chimique en phase vapeur. Le dépôt chimique en phase vapeur peut être un dépôt chimique en phase vapeur assisté par plasma (PECVD pour « *Plasma Enhanced Chimical Vapor Deposition* » en langue anglaise).

En l'absence de couche d'alumine 5, la ou les couches d'oxyde transparent conducteur 4 présentent avantageusement une épaisseur totale comprise entre 10 nm et 80 nm. Une telle gamme d'épaisseurs permet d'obtenir les meilleurs résultats en termes de tension en circuit ouvert implicite (« *implied open circuit voltage »* en langue anglaise, connue par l'acronyme iVoc) lorsque la ou les couches d'oxyde transparent conducteur 4 sont déposées par PVD ou ALD.

En présence d'une couche d'alumine 5, la ou les couches d'oxyde transparent conducteur 4 présentent avantageusement une épaisseur totale comprise entre 40 nm et 200 nm. Une telle gamme d'épaisseurs permet d'obtenir les meilleurs résultats en termes de iVoc lorsque la ou les couches d'oxyde transparent conducteur 4 sont déposées par ALD. Il a été constaté que la présence d'une couche d'alumine 5 a peu d'influence sur l'iVoc lorsque la ou les couches d'oxyde transparent conducteur 4 sont déposées par PVD.

Comme illustré aux figures 3 et 4, l'étape a) peut être exécutée de sorte qu'une couche de silicium polycristallin 6 est intercalée entre la couche d'oxyde de silicium 3 et la ou les couches d'oxyde transparent conducteur 4.

### Plasma hydrogéné

Le plasma hydrogéné appliqué lors de l'étape b) comporte avantageusement au moins un gaz sélectionné parmi NH₃ et H₂. L'étape b) peut être exécutée sous une atmosphère comportant un gaz inerte sélectionné parmi Ar, N₂.

La température à laquelle est exécutée l'étape b) est avantageusement comprise entre 340°C et 600°C, préférentiellement comprise entre 400°C et 550°C, plus préférentiellement comprise entre 400°C et 500°C.

Le plasma hydrogéné est avantageusement appliqué lors de l'étape b) selon une densité de puissance comprise entre 10⁻³ W.cm⁻² et 2.10⁻² W.cm⁻², préférentiellement comprise 5.10⁻³ W.cm⁻² et 10⁻² W.cm⁻². Le plasma hydrogéné est avantageusement appliqué lors de l'étape b) selon une pression comprise entre 1,5 Torr et 2,5 Torr (c'est-à-dire comprise entre 200 Pa et 333 Pa), préférentiellement comprise entre 1,7 Torr et 2,2 Torr (c'est-à-dire comprise entre 226 Pa et 293 Pa). L'étape b) est avantageusement exécutée pendant une durée comprise entre 5 minutes et 90 minutes, de préférence comprise entre 10 minutes et 30 minutes.

### Fabrication d'une cellule photovoltaïque

Pour une application de fabrication de cellule photovoltaïque, le procédé peut comporter une étape c) consistant à former un contact électrique sur l'empilement 1.

### L'étape c) est exécutée après l'étape b).

A titre d'exemple, le contact électrique peut être obtenu à l'aide d'une pâte de sérigraphie, électriquement conductrice, et formée sur la ou les couches d'oxyde transparent conducteur 4. La pâte de sérigraphie possède avantageusement une température de cuisson inférieure ou égale à 600°C.

### Exemple de réalisation

L'empilement 1 prévu lors de l'étape a) comporte successivement un substrat 2 à base de silicium monocristallin, une couche d'oxyde de silicium 3, une couche d'oxyde transparent conducteur 4 en oxyde de zinc dopé à l'aluminium (AZO), et une couche d'alumine 5. La couche d'oxyde de silicium 3 présente une épaisseur de l'ordre de 4 nm. La couche d'oxyde transparent conducteur 4 (ci-après TCO) présente une épaisseur de 40 nm et a été déposée par ALD. La couche d'alumine 5 présente une épaisseur de 10 nm. L'étape b) est exécutée en appliquant un plasma de NH₃, selon une densité de puissance de l'ordre de 9,2.10⁻³ W/cm². La température à laquelle est exécutée l'étape b) est de l'ordre de 500°C. Il a été possible de constater une tension en circuit ouvert implicite (« *implied open circuit voltage* » en langue anglaise, connue par l'acronyme iVoc) de l'ordre de 716 mV après l'étape b), traduisant une excellente passivation de l'interface I entre le substrat 2 et la couche d'oxyde de silicium 3. A titre de comparaison, la tension en circuit ouvert implicite de l'empilement 1 était inférieure à 580 mV avant l'étape b).

### Autres exemples de réalisation

L'empilement 1 prévu lors de l'étape a) comporte successivement un substrat 2 à base de silicium monocristallin, une couche d'oxyde de silicium 3, une couche d'oxyde transparent conducteur 4 en oxyde de zinc dopé à l'aluminium (AZO), et le cas échéant une couche d'alumine 5. La couche d'oxyde transparent conducteur 4 (ci-après TCO) présente une épaisseur variable et a été déposée par PVD ou ALD. L'étape b) est exécutée en appliquant un plasma de NH₃, selon une densité de puissance de l'ordre de 9,2.10⁻³ W/cm². La température à laquelle est exécutée l'étape b) est comprise entre 450°C et 500°C. Les résultats des expériences en termes de tension en circuit ouvert implicite (« *implied open circuit voltage »* en langue anglaise, connue par l'acronyme iVoc) sont rassemblés dans le tableau ci-après.

| Epaisseur totale (nm) du ou des TCO | Technique de dépôt du ou des TCO | Epaisseur (nm) de la couche d'alumine | iVoc (mV) |
|---|---|---|---|
| 20 | PVD | 0 | 632 |
| 40 | PVD | 0 | 595 |
| 80 | PVD | 0 | 570 |
| 20 | PVD | 10 | 575 |
| 40 | PVD | 10 | 585 |
| 80 | PVD | 10 | 602 |
| 20 | ALD | 10 | 670 |
| 40 | ALD | 10 | 630 |
| 120 | ALD | 10 | 705 |

Il a été constaté une augmentation de la valeur de iVoc (entre 14 mV et 32 mV) par rapport à un empilement 1 soumis simplement à un recuit thermique compris entre 450°C et 500°C, c'est-à-dire en l'absence d'un traitement plasma hydrogéné exécuté lors de l'étape b). Ainsi, un tel procédé selon l'invention permet d'améliorer la passivation de la surface du substrat, malgré la présence du ou des TCO 4, et ce grâce à l'étape b).

On constate de plus que la présence de la couche d'alumine 5 n'a que peu d'influence lorsque le ou les TCO 4 sont déposés par PVD. En revanche, la couche d'alumine 5 permet d'améliorer les propriétés de passivation lorsque le ou les TCO 4 sont déposés par ALD.

Selon un autre exemple de réalisation, l'empilement 1 prévu lors de l'étape a) comporte successivement un substrat 2 à base de silicium monocristallin, une couche d'oxyde de silicium 3, une monocouche d'oxyde transparent conducteur 4, en oxyde de zinc dopé à l'aluminium (AZO). La monocouche en AZO est déposée par PVD et possède une épaisseur de 40 nm. L'étape b) est exécutée en appliquant un plasma de NH₃, selon une densité de puissance de l'ordre de 9,2.10⁻³ W/cm². La température à laquelle est exécutée l'étape b) est de l'ordre de 500°C. Il a été possible de constater une tension en circuit ouvert implicite de l'ordre de 597 mV après l'étape b). La même expérience a été réalisée avec une bicouche d'oxyde transparent conducteur 4 en AZO, comportant une première couche d'AZO de 20 nm déposée par ALD et une seconde couche d'AZO de 40 nm déposée par PVD. Il a été possible de constater une tension en circuit ouvert implicite de l'ordre de 630 mV après l'étape b). On peut en conclure que l'ajout de la première couche d'AZO de 20 nm déposée par ALD permet d'augmenter la tension en circuit ouvert implicite, et ainsi améliore la passivation de l'interface entre le substrat et la couche d'oxyde de silicium.

L'invention ne se limite pas aux modes de réalisation exposés. L'homme du métier est mis à même de considérer leurs combinaisons techniquement opérantes, et de leur substituer des équivalents.

## Revendications

1. Procédé de passivation, comportant les étapes successives :
a) prévoir un empilement (1) comportant successivement un substrat (2) à base de silicium cristallin, une couche d'oxyde de silicium (3), et au moins une couche d'oxyde transparent conducteur (4) ;
b) appliquer un plasma hydrogéné à l'empilement (1), l'étape b) étant exécutée à une température adaptée de sorte que des atomes d'hydrogène du plasma hydrogéné diffusent jusqu'à l'interface (I) entre le substrat (2) et la couche d'oxyde de silicium (3).

2. Procédé selon la revendication 1, dans lequel le plasma hydrogéné appliqué lors de l'étape b) comporte au moins un gaz sélectionné parmi NH₃ et H₂.

3. Procédé selon la revendication 1 ou 2, dans lequel la température à laquelle est exécutée l'étape b) est comprise entre 340°C et 600°C, préférentiellement comprise entre 400°C et 550°C, plus préférentiellement comprise entre 400°C et 500°C.

4. Procédé selon l'une des revendications 1 à 3, dans lequel le plasma hydrogéné est appliqué lors de l'étape b) selon une densité de puissance comprise entre 10⁻³ W.cm⁻² et 2.10⁻² W.cm⁻², préférentiellement comprise 5.10⁻³ W.cm⁻² et 10⁻² W.cm⁻².

5. Procédé selon l'une des revendications 1 à 4, dans lequel le plasma hydrogéné est appliqué lors de l'étape b) selon une pression comprise entre 1,5 Torr et 2,5 Torr, préférentiellement comprise entre 1,7 Torr et 2,2 Torr.

6. Procédé selon l'une des revendications 1 à 5, dans lequel l'étape b) est exécutée sous une atmosphère comportant un gaz inerte sélectionné parmi Ar, N₂.

7. Procédé selon l'une des revendications 1 à 6, dans lequel l'étape b) est exécutée pendant une durée comprise entre 5 minutes et 90 minutes, de préférence comprise entre 10 minutes et 30 minutes.

8. Procédé selon l'une des revendications 1 à 7, dans lequel la couche d'oxyde de silicium (3) de l'empilement (1) prévu lors de l'étape a) présente une épaisseur inférieure ou égale à 4 nm, de préférence inférieure ou égale à 2 nm.

9. Procédé selon l'une des revendications 1 à 8, dans lequel la ou les couches d'oxyde transparent conducteur (4) présentent une épaisseur totale comprise entre 10 nm et 200 nm.

10. Procédé selon l'une des revendications 1 à 9, dans lequel l'oxyde transparent conducteur (4) est sélectionné parmi un oxyde d'indium et un oxyde de zinc ; l'oxyde d'indium étant de préférence choisi parmi l'oxyde d'indium-étain, un oxyde d'indium dopé au fluor, un oxyde d'indium hydrogéné, un oxyde d'indium dopé au tungstène ; l'oxyde de zinc étant de préférence choisi parmi un oxyde de zinc dopé à l'aluminium, un oxyde de zinc dopé au bore.

11. Procédé selon la revendication 10, dans lequel l'oxyde transparent conducteur (4) est sélectionné parmi un oxyde de zinc, un oxyde de zinc dopé à l'aluminium, un oxyde de zinc dopé au bore.

12. Procédé selon l'une des revendications 1 à 11, dans lequel l'étape a) comporte une étape a₁) consistant à former une couche d'alumine (5) sur la ou les couches d'oxyde transparent conducteur (4).

13. Procédé selon la revendication 12, dans lequel l'étape a₁) est exécutée de sorte que la couche d'alumine (5) présente une épaisseur inférieure ou égale à 20 nm, de préférence comprise entre 2 nm et 10 nm.

14. Procédé selon la revendication 12 ou 13, dans lequel l'étape a₁) est exécutée par une technique de dépôt choisie parmi l'ALD, un dépôt physique en phase vapeur et un dépôt chimique en phase vapeur.

15. Procédé selon l'une des revendications 1 à 14, dans lequel l'étape a) est exécutée de sorte qu'une couche de silicium polycristallin (6) est intercalée entre la couche d'oxyde de silicium (3) et la ou les couches d'oxyde transparent conducteur (4).

## Patentansprüche

1. Passivierungsverfahren, das folgende aufeinanderfolgende Schritte umfasst:
a) Bereitstellen einer Schichtanordnung (1), die nacheinander ein Substrat (2) auf Basis von kristallinem Silicium, eine Siliciumoxidschicht (3) und mindestens eine Schicht aus leitfähigem transparentem Oxid (4) aufweist;
b) Behandeln der Schichtanordnung (1) mit einem wasserstoffhaltigen Plasma, wobei Schritt b) bei einer Temperatur durchgeführt wird, die so ausgelegt ist, dass Wasserstoffatome des wasserstoffhaltigen Plasmas bis zu der Grenzfläche (I) zwischen Substrat (2) und Siliciumoxidschicht (3) diffundieren.

2. Verfahren nach Anspruch 1, wobei das in Schritt b) zur Behandlung verwendete wasserstoffhaltige Plasma mindestens ein Gas aufweist, das aus NH₃ und H₂ ausgewählt ist.

3. Verfahren nach Anspruch 1 oder 2, wobei die Temperatur, bei der Schritt b) durchgeführt wird, zwischen 340°C und 600°C, vorzugsweise zwischen 400°C und 550°C, bevorzugter zwischen 400°C und 500°C liegt.

4. Verfahren nach einem der Ansprüche 1 bis 3, wobei das wasserstoffhaltige Plasma in Schritt b) bei einer Leistungsdichte zwischen 10⁻³ W.cm⁻² und 2.10⁻² W.cm⁻², vorzugsweise zwischen 5.10⁻³ W.cm⁻² und 10⁻²W.cm⁻² zur Behandlung eingesetzt wird.

5. Verfahren nach einem der Ansprüche 1 bis 4, wobei das wasserstoffhaltige Plasma in Schritt b) bei einem Druck zwischen 1,5 Torr und 2,5 Torr, vorzugsweise zwischen 1,7 Torr und 2,2 Torr zur Behandlung eingesetzt wird.

6. Verfahren nach einem der Ansprüche 1 bis 5, wobei Schritt b) in einer Atmosphäre durchgeführt wird, die ein Inertgas umfasst, das aus Ar und N₂ ausgewählt ist.

7. Verfahren nach einem der Ansprüche 1 bis 6, wobei Schritt b) während einer Dauer zwischen 5 Minuten und 90 Minuten, vorzugsweise zwischen 10 Minuten und 30 Minuten durchgeführt wird.

8. Verfahren nach einem der Ansprüche 1 bis 7, wobei die Siliciumoxidschicht (3) der Schichtanordnung (1), die in Schritt a) bereitgestellt wird, eine Dicke von kleiner gleich 4 nm, vorzugsweise kleiner gleich 2 nm aufweist.

9. Verfahren nach einem der Ansprüche 1 bis 8, wobei die Schicht oder Schichten aus leitfähigem transparentem Oxid (4) eine Gesamtdicke zwischen 10 nm und 200 nm aufweist bzw. aufweisen.

10. Verfahren nach einem der Ansprüche 1 bis 9, wobei das leitfähige transparente Oxid (4) aus einem Indiumoxid und einem Zinkoxid ausgewählt ist; wobei das Indiumoxid vorzugsweise ausgewählt ist aus Indiumzinnoxid, einem fluordotierten Indiumoxid, einem hydrierten Indiumoxid, einem wolframdotierten Indiumoxid; wobei das Zinkoxid vorzugsweise aus einem aluminiumdotierten Zinkoxid und einem bordotierten Zinkoxid ausgewählt ist.

11. Verfahren nach Anspruch 10, wobei das leitfähige transparente Oxid (4) aus einem Zinkoxid, einem aluminiumdotierten Zinkoxid und einem bordotierten Zinkoxid ausgewählt ist.

12. Verfahren nach einem der Ansprüche 1 bis 11, wobei Schritt a) einen Schritt a₁) umfasst, der darin besteht, eine Aluminiumoxidschicht (5) auf der Schicht oder den Schichten aus leitfähigem transparentem Oxid (4) zu bilden.

13. Verfahren nach Anspruch 12, wobei Schritt a₁) derart durchgeführt wird, dass die Aluminiumoxidschicht (5) eine Dicke von kleiner gleich 20 nm, vorzugsweise zwischen 2 nm und 10 nm aufweist.

14. Verfahren nach Anspruch 12 oder 13, wobei Schritt a₁) mit einem Abscheidungsverfahren durchgeführt wird, das ausgewählt wird aus ALD, einer physikalischen Gasphasenabscheidung und einer chemischen Gasphasenabscheidung.

15. Verfahren nach einem der Ansprüche 1 bis 14, wobei Schritt a) derart durchgeführt wird, dass eine Schicht aus polykristallinem Silicium (6) zwischen der Siliciumoxidschicht (3) und der oder den Schichten aus leitfähigem transparentem Oxid (4) angeordnet ist.

## Claims

1. Passivation process comprising the successive steps of:
a) providing a stack (1) comprising, in succession, a substrate (2) based on crystalline silicon, a layer of silicon oxide (3), and at least one layer of transparent conductive oxide (4);
b) applying a hydrogen-containing plasma to the stack (1), step b) being executed at a suitable temperature so that hydrogen atoms of the hydrogen-containing plasma diffuse to the interface (I) between the substrate (2) and the layer of silicon oxide (3).

2. Process according to Claim 1, wherein the hydrogen-containing plasma applied in step b) contains at least one gas selected from NH₃ and H₂.

3. Process according to Claim 1 or 2, wherein the temperature at which step b) is executed is comprised between 340°C and 600°C, preferably comprised between 400°C and 550°C, and more preferably comprised between 400°C and 500°C.

4. Process according to one of Claims 1 to 3, wherein the hydrogen-containing plasma is applied in step b) with a power density comprised between 1×10⁻³ W.cm⁻² and 2×10⁻² W.cm⁻², and preferably comprised between 5×10⁻³ W.cm⁻² and 1×10⁻² W. cm⁻².

5. Process according to one of Claims 1 to 4, wherein the hydrogen-containing plasma is applied in step b) with a pressure comprised between 1.5 torr and 2.5 torr, and preferably comprised between 1.7 torr and 2.2 torr.

6. Process according to one of Claims 1 to 5, wherein step b) is executed under an atmosphere containing an inert gas selected from Ar and N₂.

7. Process according to one of Claims 1 to 6, wherein step b) is executed for a time comprised between 5 minutes and 90 minutes, and preferably comprised between 10 minutes and 30 minutes.

8. Process according to one of Claims 1 to 7, wherein the layer of silicon oxide (3) of the stack (1) provided in step a) has a thickness smaller than or equal to 4 nm, and preferably smaller than or equal to 2 nm.

9. Process according to one of Claims 1 to 8, wherein the one or more layers of transparent conductive oxide (4) have a total thickness comprised between 10 nm and 200 nm.

10. Process according to one of Claims 1 to 9, wherein the transparent conductive oxide (4) is selected from an indium oxide and a zinc oxide, the indium oxide preferably being chosen from indium-tin oxide, a fluorine-doped indium oxide, a hydrogen-containing indium oxide and a tungsten-doped indium oxide, and the zinc oxide preferably being chosen from an aluminium-doped zinc oxide and a boron-doped zinc oxide.

11. Process according to Claim 10, wherein the transparent conductive oxide (4) is selected from a zinc oxide, an aluminium-doped zinc oxide and a boron-doped zinc oxide.

12. Process according to one of Claims 1 to 11, wherein step a) comprises a step a₁) consisting in forming a layer of alumina (5) on the one or more layers of transparent conductive oxide (4).

13. Process according to Claim 12, wherein step a₁) is executed so that the layer of alumina (5) has a thickness smaller than or equal to 20 nm, and preferably comprised between 2 nm and 10 nm.

14. Process according to Claim 12 or 13, wherein step a₁) is executed using a deposition technique chosen from ALD, physical vapour deposition and chemical vapour deposition.

15. Process according to one of Claims 1 to 14, wherein step a) is executed so that a layer of polysilicon (6) is inserted between the layer of silicon oxide (3) and the one or more layers of transparent conductive oxide (4).
